# EUROPEAN PATENT APPLICATION

(11) **EP 2 138 612 A2**
(43) Date of publication of application: **30.12.2009**
(21) Application number: 09163139.0
(22) Date of filing: 18.06.2009
(51) Int. Cl.: C30B 29/52, F01D 5/28

(54) **Single crystal nickel-based superalloy component and manufacturing method therefor**

(30) Priority: 24.06.2008 US 144804
(71) Applicant: Honeywell International Inc., Morristown, NJ 07962 (US)
(72) Inventor: Hu, Yiping, Morristown, NJ 07962-2245 (US)
(74) Representative: Buckley, Guy Julian

(57) **Abstract**

Single crystal nickel-based superalloy compositions, single crystal nickel-based superalloy components, and methods of fabricating such components are provided. In an embodiment, by way of example only, a single crystal nickel-based superalloy composition consists essentially of, in weight percent from about 3.8 to about 4.2 percent chromium, from about 10.0 to about 10.5 percent cobalt, from about 1.8 to about 2.2 percent molybdenum, from about 4.8 to about 5.2 percent tungsten, from about 5.8 to about 6.2 percent rheniun, from about 5.5 to about 5.8 percent aluminum, from about 5.8 to about 6.2 percent tantalum, from about 3.8 to about 4.2 percent ruthenium, from about 0.13 to about 0.17 percent hafnium, and a balance of nickel.

## Description

### TECHNICAL FIELD

The inventive subject matter generally relates to materials for gas turbine engine applications, and more particularly relates to single crystal nickel-based superalloy compositions and components of gas turbine engines made therefrom.

### BACKGROUND

Turbine engines are used as the primary power source for various kinds of aircrafts. The engines may also serve as auxiliary power sources that drive air compressors, hydraulic pumps, and industrial electrical power generators. Most turbine engines generally follow the same basic power generation procedure. Compressed air is mixed with fuel and burned, and the expanding hot combustion gases are directed against stationary turbine vanes in the engine. The vanes turn the high velocity gas flow partially sideways to impinge onto turbine blades mounted on a rotatable turbine disk. The force of the impinging gas causes the turbine disk to spin at high speed. Jet propulsion engines use the power created by the rotating turbine disk to draw more air into the engine, and the high velocity combustion gas is passed out of the gas turbine aft end to create forward thrust. Other engines use this power to turn one or more propellers, electrical generators, or other devices. Because fuel efficiency increases as engine operating temperatures increase, turbine blades and vanes are often fabricated from high-temperature materials, such as precipitation-strengthening superalloys. When in a cast form, these superalloys, which include nickel- and cobalt-based alloys, possess many properties that may be desirable during exposure to the engine operating temperatures. For example, these superalloys may have better elevated- temperature strength and environmental resistance. However, although known precipitation-strengthening superalloys exhibit superior mechanical properties under high temperature and high pressure conditions, they may be subject to oxidation and corrosion attack when exposed to high-temperature and highly-pressurized gases in the turbine engine.

To protect the superalloys from oxidation and corrosion attacks, the turbine engine airfoils may include a coating system thereon. In some cases, the coating system may include a thermal barrier coating (TBC). Typical TBCs may be formed from yttria stabilized zirconia (YSZ) and/or yttria stabilized zirconia doped with other oxides such as Gd₂O₃, TiO₂, and the like. The coating system may further include an environment-resistant bond coat underneath the TBC to extend its service life. Bond coats may be overlay coatings that may include, for example, MCrAlX, where M is a metallic element like nickel, cobalt, and/or a combination of both nickel and cobalt, and X is yttrium or other reactive and metallic elements. A bond coat can also be a diffusion coating such as a simple aluminide coating, a reactive element-modified aluminide coating, a platinum-modified aluminide coating or a reactive element-modified platinum aluminide coating. Thus, during exposure to high temperature, such as during ordinary service use thereof, the bond coating oxidizes first to form a thermally grown oxide (TGO) to protect underlying bond coat from further oxidation. However, if the TGO layer grows too quickly and/or becomes too thick, adherence of the TBC to the bond coat may be weakened, and cracks between the TBC and the TGO as well as between the TGO and the bond coat may form. In such case, the TBC may prematurely spall off, thus decreasing the service life of the superalloy component.

Accordingly, it is desirable to provide an improved superalloy composition for gas turbine engine applications, wherein the superalloy has improved elevated-temperature mechanical properties and environment-resistant performance. In addition, it is desirable for the improved superalloy composition to be relatively inexpensive to produce and to incorporate into engine systems. Furthermore, other desirable features and characteristics of the inventive subject matter will become apparent from the subsequent detailed description of the inventive subject matter and the appended claims, taken in conjunction with the accompanying drawings and this background of the inventive subject matter.

### BRIEF SUMMARY

Single crystal nickel-based superalloy compositions, single crystal nickel-based superalloy components, and methods of fabricating such components are provided.

In an embodiment, by way of example only, a single crystal nickel-based superalloy composition consists essentially of, in weight percent from about 3.8 to about 4.2 percent chromium, from about 10.0 to about 10.5 percent cobalt, from about 1.8 to about 2.2 percent molybdenum, from about 4.8 to about 5.2 percent tungsten, from about 5.8 to about 6.2 percent rhenium, from about 5.5 to about 5.8 percent aluminum, from about 5.8 to about 6.2 percent tantalum, from about 3.8 to about 4.2 percent ruthenium, from about 0.13 to about 0.17 percent hafnium, and a balance of nickel.

In another embodiment, by way of example only, a single crystal nickel-based superalloy component is fabricated from a single crystal superalloy consisting essentially of, in weight percent from about 3.8 to about 4.2 percent chromium, from about 10.0 to about 10.5 percent cobalt, from about 1.8 to about 2.2 percent molybdenum, from about 4.8 to about 5.2 percent tungsten, from about 5.8 to about 6.2 percent rhenium, from about 5.5 to about 5.8 percent aluminum, from about 5.8 to about 6.2 percent tantalum, from about 3.8 to about 4.2 percent ruthenium, from about 0.13 to about 0.17 percent hafnium, and a balance of nickel.

In still another embodiment, by way of example only, a method for fabricating a single crystal nickel-based superalloy component includes the steps of providing an alloy comprising, in weight percent from about 3.8 to about 4.2 percent chromium, from about 10.0 to about 10.5 percent cobalt, from about 1.8 to about 2.2 percent molybdenum, from about 4.8 to about 5.2 percent tungsten, from about 5.8 to about 6.2 percent rhenium, from about 5.5 to about 5.8 percent aluminum, from about 5.8 to about 6.2 percent tantalum, from about 3.8 to about 4.2 percent ruthenium, from about 0.13 to about 0.17 percent hafnium, and a balance of nickel and fabricating a single crystal component from the alloy.

### BRIEF DESCRIPTION OF THE DRAWINGS

The inventive subject matter will hereinafter be described in conjunction with the following drawing figures, wherein like numerals denote like elements, and wherein:

FIG. 1 is a perspective view of a component, according to an embodiment;

FIG. 2 is a cross-sectional view of a portion of a component, according to an embodiment; and

FIG. 3 is a flow diagram of a process for fabricating a single crystal nickel-based superalloy component, according to an embodiment.

### DETAILED DESCRIPTION

The following detailed description of the inventive subject matter is merely exemplary in nature and is not intended to limit the inventive subject matter or the application and uses of the inventive subject matter. Furthermore, there is no intention to be bound by any theory presented in the preceding background of the inventive subject matter or the following detailed description of the inventive subject matter.

A superalloy composition is provided that may have improved elevated-temperature properties compared to conventional superalloy compositions. In an embodiment, the inclusion of certain elements, such as molybdenum and rhenium, may improve stress rupture strength and creep resistance, when the superalloy is exposed to engine operating temperatures, such as temperatures greater than about 2200° F (1205° C). In another embodiment, when element ruthenium is included in the superalloy composition, phase stability of the superalloy may be greatly improved.

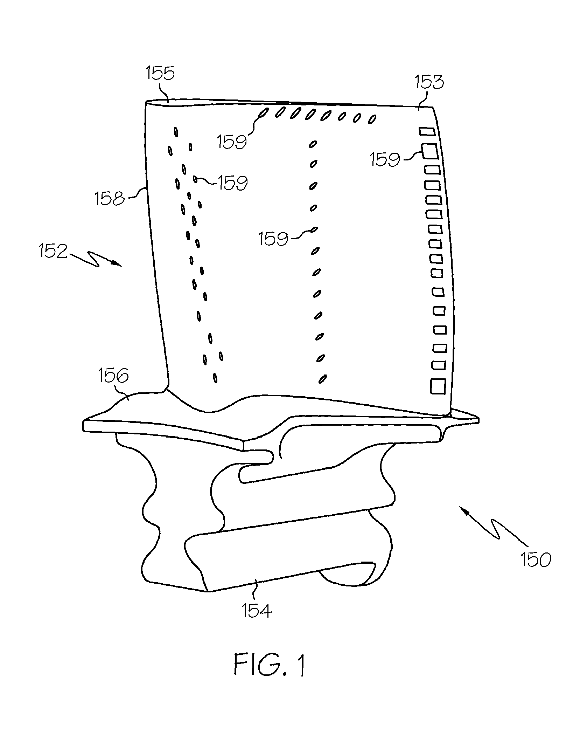

The superalloy composition may be embodied in a single crystal nickel-based superalloy component. FIG. 1 is a perspective view of a component 150, according to an embodiment. Here, the component 150 is shown as turbine blade. However, in other embodiments, the component 150 may be a turbine vane or other component that may be implemented in a gas turbine engine, or other high-temperature system. In an embodiment, the component 150 includes an airfoil 152 including a pressure side surface 153, an attachment portion 154, a leading edge 158 including a blade tip 155, and a platform 156. In accordance with an embodiment, the component 150 may be formed with a non-illustrated outer shroud attached to the tip 155. The component 150 may have non-illustrated internal air-cooling passages that remove heat from the turbine airfoil. After the internal air has absorbed heat from the superalloy blade, the air is discharged into a combustion gas flow path through passages 159 in the airfoil wall. Although the turbine component 150 is illustrated as including certain parts and having a particular shape and dimension, different shapes, dimensions and sizes may be alternatively employed depending on particular gas turbine engine models and particular applications.

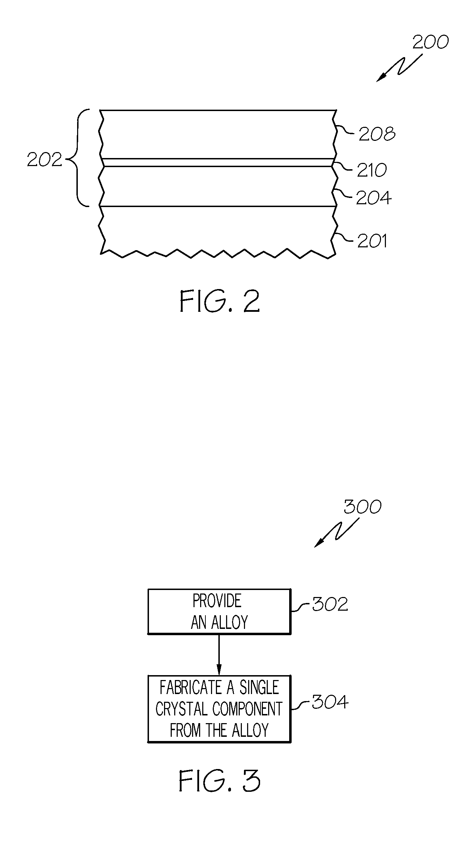

FIG. 2 is a cross-sectional view of a portion of a component 200, according to an embodiment. The component 200 may be, for example, a turbine airfoil such as the turbine blade shown in FIG. 1 and may include a protective coating system 202 disposed over a substrate 201. In an embodiment, the protective coating system 202 may include a bond coating 204, a thermal barrier coating 208, and one or more intermediate layers therebetween, such as a thermally grown oxide (TGO) 210. In one embodiment, the bond coating 204 is a diffusion aluminide coating. The diffusion aluminide coating may be formed by depositing an aluminum layer over the component 200, and subsequently interdiffusing the aluminum layer with the substrate. According to one embodiment, the diffusion aluminide coating is a simple diffusion aluminide, including a single layer made up of aluminum diffused into the substrate 201. In another embodiment, the diffusion aluminide coating may have a more complex structure and may include one or more additional metallic layers that are diffused into the aluminum and/or the substrate 201. For example, an additional metallic layer may include a platinum layer, a hafnium and/or a zirconium layer, or a co-deposited hafnium, zirconium, and platinum layer. In another embodiment, the bond coating 204 may be an overlay coating comprising MCrAlX, wherein M is an element selected from cobalt, nickel, or combinations thereof, and X is an element selected from hafnium, zirconium, yttrium, tantalum, rhenium, ruthenium, palladium, platinum, silicon, or combinations thereof. Some examples of MCrAlX compositions include NiCoCrAlY and CoNiCrAlY. In another exemplary embodiment, the bond coating 204 may include a combination of two types of bond coatings, such as a diffusion aluminide coating formed on an MCrAlX coating. In any case, the bond coating 204 may have a thickness in a range of from about 25 microns (µm) to about 150 µm, according to an embodiment. In other embodiments, the thickness of the bond coating 204 may be greater or less.

The thermal barrier coating 208 may be formed over the bond coating 204 and may comprise, for example, a ceramic. In one example, the thermal barrier coating 208 may comprise a partially stabilized zirconia-based thermal barrier coating, such as yttria stabilized zirconia (YSZ). In an embodiment, the thermal barrier coating may comprise yttria stabilized zirconia doped with other oxides, such as Gd₂O₃, TiO₂, and the like. In another embodiment, the thermal barrier coating 208 may have a thickness that may vary and may be, for example, in a range from about 50 µm to about 300 µm. In other embodiments, the thickness of the thermal barrier coating 208 may be in a range of from about 100 µm to about 250 µm. In still other embodiments, the thermal barrier coating 208 may be thicker or thinner than the aforementioned ranges.

The thermally-grown oxide layer 210 may be located between the bond coating 204 and the thermal barrier coating 208. In an embodiment, the thermally-grown oxide layer 210 may be grown from aluminum in the above-mentioned materials that comprise the bond coating 204. For example, during bond coating 204 exposed to high temperature in air or oxygen-containing atmosphere, oxidation may occur thereon to result in the formation of the oxide layer 210. In one embodiment, the thermally-grown oxide layer 210 may be relatively thin, and may be less than 2 µm thick.

The substrate 201 over which the coating system 202 is disposed may be fabricated from a single crystal superalloy material. A "single crystal superalloy material" may be defined as a superalloy material formed to have a single crystallographic orientation throughout its entirety and being substantially free of high angle boundaries. In some embodiments, an incidental amount of low angle boundaries, which are commonly defined as the boundaries between adjacent grains whose crystallographic orientation differs by less than about 5 degrees, such as tilt or twist boundaries, may be present within the single crystal superalloy material after solidification and formation of the single crystal superalloy material, or after some deformation of the component during creep or other deformation process. However, preferably, low angle boundaries are not present in the single crystal superalloy component.

The single crystal superalloy material may be comprised of a material having a microstructure that, after heat treatment, forms an array of gamma prime precipitates in a matrix. In an embodiment, the matrix may comprise nickel, which has been strengthened by the addition of various alloying elements. To achieve a cooperative optimization of physical, chemical, and mechanical properties of a completed component and to optimize the retention of such properties during the operating lifetime of the component, the alloying elements are selected, which may, either alone or in combination, exhibit desired properties. Additionally, the selection of the alloying elements may also depend on an ability to provide creep strength, phase stability, and environmental resistance, to the single crystal component.

In an embodiment, one or more of the alloying elements may be selected from chromium, cobalt, molybdenum, tungsten, rhenium, aluminum, tantalum, ruthenium, hafnium, yttrium, lanthanum, carbon, and boron. According to an embodiment, these elements may be included to form a superalloy composition. In an embodiment, the superalloy composition may include, in weight percent, from about 3.8 to about 4.2 percent chromium, from about 10.0 to about 10.5 percent cobalt, from about 1.8 to about 2.2 percent molybdenum, from about 5.8 to about 6.2 percent rhenium, from about 3.8 to about 4.2 percent ruthenium, from about 5.5 to about 5.8 percent aluminum, from about 5.8 to about 6.2 percent tantalum, from about 4.8 to about 5.2 percent tungsten, from about 0.13 to about 0.17 percent hafnium, and a balance of nickel. In accordance with another embodiment, the superalloy composition may further include, in weight percent, from about 0.001 to about 0.015 weight percent of a material selected from the group consisting of yttrium, lanthanum, and a combination thereof. In still another embodiment, the superalloy composition may still further include, in weight percent, from about 0.02 to about 0.06 percent carbon and from about 0.003 to about 0.006 percent boron. In any case, in an embodiment, a sum of molybdenum plus tungsten plus rhenium plus tantalum plus ruthenium present in the superalloy composition may be from about 20.0 to about 25.0 weight percent.

It has been found that the inclusion of molybdenum and rhenium in the composition improves creep strength and stress rupture property of the alloy by increasing lattice misfit between the gamma matrix and the gamma-prime precipitates. In this regard, in an embodiment, an amount of from about 1.8 to about 2.2 percent molybdenum, by weight, and an amount of from about 5.8 to about 6.2 percent of rhenium, by weight may be included. Additionally, rhenium may refine the size of the gamma-prime precipitates, which may contribute to the improved strength of the gamma matrix. Rhenium may also improve the creep strength of the alloy by decreasing a coarsening rate of the gamma-prime precipitates, during extended elevated temperature exposure. It has also been found that the addition of ruthenium to the superalloy composition promotes phase stability. Moreover, by balancing elements cobalt and chromium and strengthening elements such as the molybdenum, tungsten, tantalum, rhenium, and ruthenium in the range of from about 20.0 to about 25.0 weight percent, the formation of topologically close-packed phases (TCP) such as P and R, and sigma phases may be avoided.

FIG. 3 is a flow diagram of a process 300 for fabricating a single crystal superalloy component, according to an embodiment. First, an alloy of the above-described superalloy composition is initially provided, step 302. In an embodiment, the alloy includes the aforementioned superalloy composition. Next, the single crystal superalloy component then may be fabricated, step 304. In accordance with an embodiment, the alloy of step 302 may be formed into a single crystal turbine hardware. Without further processing, the single crystal hardware would contain gamma-prime precipitates (referred to as cooling gamma-prime) having a variety of sizes. If a further solution and aging heat treatment procedure is performed, the gamma-prime precipitate phase dissolves into the gamma matrix and is reprecipitated out during an aging treatment conducted at a lower temperature.

To dissolve the gamma-prime phase into the gamma matrix, the single crystal piece is heated to a temperature which is greater than the solvus temperature of the gamma-prime phase, but less than the melting temperature of the alloy. The melting temperature, termed the solidus temperature for an alloy which melts over a temperature range, should be sufficiently greater than the solvus temperature so that the single crystal piece may be heated and maintained within the temperature range between the solvus and the solidus for a time sufficiently long to dissolve the gamma-prime precipitation phase into the gamma matrix. The solidus temperature is about 2,400° F (about 1315.56°C) to 2,450° F (about 1343.33°C), and accurate control to within a few degrees in commercial heat treating equipment is not available. In an embodiment, the solidus may be at least about 15°F (about 8.3°C) greater than the solvus temperature for the gamma-prime precipitates.

The "heat treatment window" or difference between the gamma-prime solvus and the alloy solidus temperatures preferably is at least at 15°F (about 8.3°C), and more preferably is greater than about 50°F (about 27.8°C). In an embodiment of heat treatment of the cast single crystal pieces, the pieces are solution heat treated at a temperature of about 2,400°F (about 1315.6°C) for a period of about three hours, to dissolve the gamma-prime precipitation phase formed during solidification, into the gamma matrix. The solution heat treatment may be accomplished at any temperature within the heat treatment window between the gamma-prime solvus and the solidus temperatures. Greater temperatures allow shorter heat treatment times. However, the heat treatment temperature is not raised to a maximum level, to allow a margin of error in the heat treatment equipment. After the heat treating process is completed, the solution heat-treated single crystal pieces are rapidly cooled to supersaturate the matrix with the gamma-prime forming elements. A fast inert gas fan cool to a temperature of less than about 1,000°F (about 537.78°C) has been found sufficient to achieve the necessary supersaturation.

Following the solution heat treatment and supersaturation cooling, the solution heat-treated single crystal pieces are aged to precipitate the gamma-prime particles from the gamma matrix. The aging heat treatment can be separated from coating treatment or combined with the coating treatment. In an embodiment, the aging heat treatment is conducted at 1150°C for 4 hours, followed by 1080°C for 4 hours and 899°C for 4 to 20 hours. As noted previously, gas turbine components are typically coated with a corrosion- and oxidation-resistant coating and thermal barrier coating prior to use. During the coating procedure, the component being coated is heated to elevated temperatures. In an embodiment, the component is heated to a temperature of about 1,950°F (about 1065.56°C) for about four hours. This heat treatment causes some precipitation of the gamma-prime phase from the gamma matrix, thus partially accomplishing the aging heat treatment. The aging heat treatment may be completed by a further elevated temperature exposure, separate from the coating procedure. A sufficient additional aging heat treatment is accomplished at a temperature of about 1,650°F (about 899°C) for a time of from about four to about twenty hours, following the heat treatment at 1,950°F (about 1065.56°C) for four hours. The aging heat treatment is not limited to the aforementioned heat treatment sequence, but instead may be accomplished by any acceptable approach which precipitates the desired volume fraction of gamma-prime particles, morphology and size within the gamma matrix, wherein the precipitation may occur from the supersaturated heat treated gamma matrix.

In some cases, the microstructure of the as-solidified single crystals may include irregular gamma-prime particles and regions of gamma-prime eutectic phases. The solution heat treatment may dissolve the irregular gamma-prime particles and most or all the gamma-prime eutectic constituent into the gamma matrix. The subsequent aging treatment precipitates an array of gamma-prime precipitates having a generally cuboidal shape and relatively uniform size. The gamma-prime precipitates may vary from about 0.3 to about 0.5 microns in size.

To fabricate the single crystal superalloy component from the single crystal superalloy mentioned above, vacuum-induction melting and casting processes may be used. In an embodiment, a thermal gradient solidification method may be employed. Here, molten metal of the superalloy composition is poured into a heat resistant ceramic mold having essentially the desired shape of the final fabricated component. The mold and molten metal contained therein are placed within a furnace, induction heating coil, or other heating device to melt the metal, and the mold and molten metal are gradually cooled in a temperature gradient. In this process, metal adjacent the cooler end of the mold solidifies first, and the interface between the solidified and liquid metal gradually moves through the metal as cooling continues. Such thermal gradient solidification can be accomplished by placing a chill block adjacent one end of the mold and then turning off the heat source, allowing the mold and molten metal to cool and solidify in a controlled desirable temperature gradient. Alternatively, the mold and molten metal can be gradually withdrawn from the heat source.

It is found that certain crystallographic orientations such as <001> grow to the exclusion of others during such a thermal gradient solidification process, so that a single grain becomes dominant throughout the article. Techniques have been employed to promote the formation of the single crystal orientation rapidly, so that substantially all the article has the same single crystal orientation. Such techniques include seeding whereby an oriented single crystal starting material is positioned adjacent the metal first solidified, so that the metal initially develops that orientation. Another technique is a geometrical selection process. However, other techniques for forming a single crystal alternatively may be used. For example, a liquid metal cooling process or cast may be used to fabricate single crystal turbine components. In this process, a nickel-based superalloy is melted and poured into a ceramic mold placed inside a multi-zone heater. For solidification, the cast components are immersed at a constant rate into a liquid tin bath.

Accordingly, single crystal nickel-based superalloy compositions for hot-section components of gas turbine engines, such as gas turbine blades and vanes, have been provided. The alloy compositions provide such components with mechanical and environment-resistant properties that may be superior to those of traditional superalloy materials.

While at least one exemplary embodiment has been presented in the foregoing detailed description of the inventive subject matter, it should be appreciated that a vast number of variations exist. It should also be appreciated that the exemplary embodiment or exemplary embodiments are only examples, and are not intended to limit the scope, applicability, or configuration of the inventive subject matter in any way. Rather, the foregoing detailed description will provide those skilled in the art with a convenient road map for implementing an exemplary embodiment of the inventive subject matter, it being understood that various changes may be made in the function and arrangement of elements described in an exemplary embodiment without departing from the scope of the inventive subject matter as set forth in the appended claims and their legal equivalents.

## Claims

1. A single crystal nickel-based superalloy composition consisting essentially of, in weight percent:
from about 3.8 to about 4.2 percent chromium;
from about 10.0 to about 10.5 percent cobalt;
from about 1.8 to about 2.2 percent molybdenum;
from about 4.8 to about 5.2 percent tungsten;
from about 5.8 to about 6.2 percent rhenium;
from about 5.5 to about 5.8 percent aluminum;
from about 5.8 to about 6.2 percent tantalum;
from about 3.8 to about 4.2 percent ruthenium;
from about 0.13 to about 0.17 percent hafnium; and
a balance of nickel.

2. The single crystal nickel-based superalloy composition of claim 1, further consisting essentially of from about 0.001 to about 0.015 weight percent of a material selected from a group consisting of yttrium, lanthanum, and a combination thereof.

3. The single crystal nickel-based superalloy composition of claim 2, further consisting essentially of from about 0.02 to about 0.06 weight percent carbon and from about 0.003 to about 0.006 weight percent boron.

4. The single crystal nickel-based superalloy composition of claim 1, wherein a sum of the molybdenum, tungsten, ruthenium, tantalum, and rhenium is from about 20.0 to about 25.0 weight percent.
